# EUROPEAN PATENT APPLICATION

(11) **EP 4 672 309 A1**
(43) Date of publication of application: **31.12.2025**
(21) Application number: 24185103.9
(22) Date of filing: 27.06.2024
(51) Int. Cl.: H01L 21/67

(54) **METHOD FOR LIGHT-INDUCED RELEASE OF ONE OR MORE COMPONENTS FROM A DONOR SUBSTRATE TO AN ACCEPTOR SUBSTRATE, AND A DONOR SUBSTRATE AND SYSTEM THEREFOR**

(71) Applicant: Nederlandse Organisatie voor toegepast-natuurwetenschappelijk Onderzoek TNO, 2595 DA 's-Gravenhage (NL)
(72) Inventor: ARUTINOV, Gari, 2595 DA 's-Gravenhage (NL); VAN DEN BRAND, Jeroen, 2595 DA 's-Gravenhage (NL)
(74) Representative: V.O.

(57) **Abstract**

The present document relates to a method for light-induced release of one or more components from a donor substrate to an acceptor substrate, and further relates to a donor substrate therefor. The melting layer of the release stack is provided with a predefined thickness for predefining the amount of optical energy to be received for releasing the at least one component, such as to establish a predefined release period determined by the optical power of the light beam. A full surface of at least one component is scanned, during a scan period shorter than the predefined release period, with a light beam along a scanning path, for providing the optical energy to the absorption layer, for releasing the at least one component.

## Description

### Field of the invention

The present invention is directed at a method for light-induced release of one or more components from a donor substrate to an acceptor substrate, and is further directed at a donor substrate and system therefor.

### Background

Semiconductor devices and photonics components are extremely fragile, due in part to their small sizes and high aspect ratios. As such, assembly of such devices requires complex pick-and-place equipment to transfer the components without damaging them. This equipment is expensive and intrinsically slow, and at best provides a low transfer yield.

### Summary of the invention

It is an object of the present invention to provide a method and means that overcome the abovementioned drawbacks, and in particular enable selective and rapid transfer of components of any size, in an energy-efficient and cost-efficient manner, minimizing the risk of damage to the components.

To this end, there is provided herewith, in accordance with a first aspect of the invention, a method of light-induced release of one or more components from a donor substrate to an acceptor substrate, wherein the method comprises:
providing the donor substrate, the donor substrate comprising a transparent carrier for being illuminated with a light beam from a light source, the light beam having an optical power and the light beam having a beam diameter defining a cross-section of the light beam, the donor substrate further comprising a stack of layers forming a release stack on the transparent carrier for receiving optical energy from the light beam for releasing of at least one of the one or more components to the acceptor substrate after a release period, wherein the release period is determined by an amount of received optical energy necessary for releasing the at least one component, wherein the release stack comprises:
   - an absorption layer for absorbing the optical energy, the absorption layer having a first melting temperature;
   - a melting layer for being melted by heat from the absorption layer, the melting layer having a second melting temperature below the first melting temperature; and
   - an adhesive layer for adhering the components to the melting layer, and for releasing the at least one component to the acceptor substrate when the melting layer is in a molten state; wherein the method further comprises:
providing the melting layer having a predefined thickness for predefining the amount of optical energy to be received for releasing the at least one component, such as to establish a predefined release period determined by the optical power of the light beam; and
scanning, during a scan period shorter than the predefined release period, a full surface of the at least one component with the light beam along a scanning path, for providing the optical energy to the absorption layer, for releasing the at least one component.

For small micro-components, known transfer techniques employ a donor substrate having a carrier with the micro-components to be transferred attached thereto. To facilitate the transfer, the donor substrate is provided with a release stack that enables to release the component upon illumination of the release stack. These techniques enable selectively transferring micro-components from the donor substrate to the acceptor substrate in a controlled manner, but have their limitations in scalability.

Some of these known techniques deploy a low gas generation laser release stack for rapid, non-explosive and controlled transfer of components from the release stack to the acceptor substrate. This approach prevents damage to the components, such as clacking, and is suitable for small components. However, a certain amount of light beam fluence (optical energy delivered per unit of area) is required to be provided to the release stack for this technique to work. Therefore, the laser power required scales with the surface area of the component to be transferred, and this technique thereby becomes much less attractive or even unsuitable for larger components. This scaling restricts the versatility of the technique in handling components of varying sizes.

By providing the melting layer having a predefined thickness, the amount of optical energy to be received for releasing the at least one component is predefined and a predefined release period is thereby established. As a consequence, a full surface of the at least one component can be scanned with the light beam along a scanning path, during a scan period shorter than the predefined release period. In this way, the method of the first aspect of the invention is able to provide the amount of optical energy required for releasing the at least one component to the absorption layer, regardless of the size of the component and without the need for employing high-power lasers. The invention therefore advantageously makes the light-induced transfer techniques suitable for larger components.

The light beam incident on the transparent carrier passes through the carrier and reaches the absorption layer of the release stack. The optical energy of the light beam is then absorbed, such that the absorption layer generates heat therein. The heat consequently melts the melting layer and brings it into a molten, liquid state. The melting temperature of the absorption layer is higher than the melting temperature of the melting layer, such that the absorption layer can remain solid while the melting layer is melted. Once the melting layer is in a molten state, release of the component, which adheres to the release stack via the adhesion layer, occurs via a process of de-wetting. The surface energy of the absorption layer is higher than the surface tension of the molten melting layer. At the same time, the surface tension of the molten melting layer is higher than the surface energy of the adhesion layer. Therefore, when the melting layer is molten, adhesion between the absorption layer and melting layer will be maintained, but adhesion between the melting layer and the adhesion layer will be lost, resulting in the release of the component. This de-wetting process occurs after a release period. It is necessary for a controlled release, wherein the component is released from the donor substrate evenly across the full surface rather than obliquely, to scan the full surface of the component within a scanning period shorter than the release period, because the melting layer must be in a molten state across the full surface of the component before the release occurs after the release period. The scan period is typically on the order of 10 microseconds. By scanning the full surface of the component to be transferred, rather than illuminating the full surface of the component at once, the width of the beam illuminating the transparent carrier advantageously does not need to increase with the dimensions of the component. The method thereby removes the need for a powerful laser capable of providing the required light beam fluence in a larger surface area.

In accordance with some embodiments of the invention, the melting layer of the donor substrate is provided having a thickness such that the release period is substantially longer than the scan period. The melting layer of the donor substrate can for example be provided with a large thickness, such that the time it takes for the heat generated in the absorption layer of the release stack to be conducted through the melting layer is increased. This thereby increases the release period to be substantially longer than the scan period. The release period may for example be on the order of milliseconds. Advantageously, this further enhances the controlled release of the at least one component to the acceptor substrate, because delays between the moments that different sides of a component are subjected to the energy from the light source are made negligible with respect to the release period. It is therefore ensured in these embodiments, that the release period is sufficiently long for enabling the full surface of the component to be scanned, rather than illuminated at once.

In accordance with some embodiments of the invention, the beam diameter of the light beam is controllable, and the method comprises a step of determining the beam diameter such as to provide the beam having a predefined light beam fluence. In these embodiments, the width of the light beam when incident on the donor substrate may e.g. be adjustable via beam-shaping optics. In alternative embodiments, wherein the beam diameter is fixed, the path to be traversed in the scanning step can be calculated directly. But in embodiments with an adjustable beam diameter, there advantageously is an additional degree of freedom. A smaller beam diameter means a higher light beam fluence, because the optical energy of the light beam is confined in a smaller cross-section. But a smaller beam diameter also means a shorter release period, because the amount of optical energy per unit of area required for the release is delivered more quickly. In light of this trade-off, these embodiments enable to find an optimal scanning path for scanning components. Additionally, by tuning the illumination width according to the method of these embodiments, such that the illumination width is confined to the dimensions of a specific component, selective release of closely spaced components is enabled without the use of masks.

In accordance with some embodiments of the invention, based on the beam diameter, the method further comprises, prior to scanning the full surface of the at least one component, determining the scanning path of the light beam such that the scanning path completely covers said full surface during said scanning. For example, if the full surface of the component is scanned in a straight line, the width of the light beam will be wider than in the case where the full surface of the component is scanned along a meandering path.

In accordance with some embodiments of the invention, the method further comprises, prior to scanning the full surface of the at least one component, controlling the optical power of the light beam for illuminating the carrier. It may be desired to adjust the optical power that is delivered to the donor substrate, for example to optimize the light beam fluence for increasing the release period or to prevent damage to the components. Predetermining the optical power enables for example to set it to a minimum level required to trigger the release by de-wetting, or alternatively to set it to a maximum level that does not cause damage to the components.

In accordance with some embodiments of the invention, the method further comprises, prior to scanning the full surface of the at least one component, determining a scan velocity of the light beam dependent on at least one of: the beam diameter, the scanning path or the optical power, for predetermining the scan period for scanning the full surface.

Where dependent on the beam diameter, determining the scan velocity enables to increase or decrease the beam diameter without altering the light beam fluence, thereby leaving the release period unaffected. Alternatively, the release period may be further increased by increasing the scan velocity, as this increases the release period. This further increases the suitability of the method according to the first aspect of the invention for large components.

Where dependent on the scanning path, determining the scan velocity advantageously enables to further optimize the scanning step in terms of energy and time efficiency. By adjusting how quickly the light beam traverses a scanning path, the light beam fluence per unit of time can be tuned.

Where dependent on the optical power, determining the scan velocity enables using lower-powered lasers for the light-induced release of larger components, by decreasing the scan velocity while keeping the scan period below the release period. This further increases the method's suitability for larger components.

In accordance with some embodiments of the invention, the release period is at least twice as long as the scan period, preferably at least five times as long as the scan period, more preferably at least ten times as long as the scan period.

In accordance with some embodiments of the invention, the scanning path is a straight linear path. Alternatively, the scanning path is a set of adjacent linear subpaths, wherein, starting from a first subpath arranged along an outer edge of the full surface of the at least one component, the full surface is scanned by consecutively scanning an adjacent subpath. Alternatively, the scanning path is a spiraling path between a center point near a center of the target surface portion and an outer point near an outer edge of the target surface portion. The case where the scanning path is a straight line is the simplest case. In these embodiments, the scanning period will typically also be the shortest, as a length of the component has to be traversed only once. However, that also means that the width of the light beam will have to be the largest. Furthermore, these scanning paths are advantageous for the release of components that have very high aspect ratios, for example on the order of 2, on the order of 5, on the order of 10 or larger. In alternative embodiments, wherein the scanning path is a set of adjacent subpaths, the scanning period will typically be longer, but such a scanning path enables the use of a more narrow light beam. A set of adjacent linear subpaths may be traversed for example along a meandering path, where the starting point of a subsequent subpath lies adjacent to the end point of a current subpath. Alternatively, such a path may be scanned iteratively, wherein the starting point of a subsequent subpath lies adjacent to the starting point of a current subpath. These embodiments are advantageous for components that have lower, but still high aspect ratios, for example on the order of 1.5 or larger. In alternative embodiments, wherein the scanning path is a spiraling path, the path may be traversed either from the center point towards the outer point, or from the outer point towards the center point. These embodiments, especially in the former case, have the further advantage that the delay between moments at which different sides of a component are released to the acceptor substrate are minimal.

In accordance with some embodiments of the invention, the light beam is a pulsed light beam having a predetermined laser period, wherein one of: the scan period is shorter than the laser period, such that the full surface of the at least one component is scanned within a single laser period; or the scan period is longer than the laser period, such that the full surface of the at least one component is scanned within a plurality of laser periods. In the former case, a pulse of long duration relative to the scan period is used for scanning across the full surface area of the at least one component. This ensures that the full surface of the at least one component is scanned within the duration of a single pulse. This is advantageous for achieving a controlled release, wherein the component is released from the donor substrate evenly across the full surface rather than obliquely, because it makes it easier to make sure that the scan period is much shorter than the release period. Alternatively however, the scan period may be longer than the laser period, resulting in the surface being scanned over multiple laser periods. In this case, the surface is illuminated multiple times in different portions thereof as the laser pulses repeatedly during scanning. This allows for increased signal accumulation and higher precision in the measurement, as different points on the surface individually receive exposure.

In accordance with a second aspect of the invention, there is provided herewith a donor substrate for use in a method according to any one or more of the preceding claims, for a light-induced release of one or more components to an acceptor substrate, the donor substrate comprising a transparent carrier for being illuminated with a light beam from a light source, the light beam having an optical power and the light beam having a beam diameter defining a cross-section of the light beam, the donor substrate further comprising a stack of layers forming a release stack on the transparent carrier for receiving optical energy from the light beam for releasing of at least one of the one or more components to the acceptor substrate after a release period, wherein the release period is determined by an amount of received optical energy necessary for releasing the at least one component, wherein the release stack comprises:
- an absorption layer for absorbing the optical energy, the absorption layer having a first melting temperature;
- a melting layer for being melted by heat from the absorption layer, the melting layer having a second melting temperature below the first melting temperature; and
- an adhesive layer for adhering the components to the melting layer, and for releasing the at least one component to the acceptor substrate when the melting layer is in a molten state,
wherein the melting layer has a thickness such as to predetermine the amount of optical energy to be received for releasing the at least one component, such as to establish a predefined release period determined by the optical power of the light beam in use, such as to enable the release period to include a scan period shorter than the predefined release period, for enabling scanning of a full surface of the at least one component with the light beam along a scanning path, for providing the optical energy to the absorption layer, for releasing the at least one component.

In use, the light beam incident on the transparent carrier passes through the carrier and reaches the absorption layer of the release stack. The optical energy of the light beam is then absorbed, such that the absorption layer generates heat therein. The heat consequently melts the melting layer and brings it into a molten, liquid state. The melting temperature of the absorption layer is higher than the melting temperature of the melting layer, such that the absorption layer can remain solid while the melting layer is melted. Once the melting layer is in a molten state, release of the component, which adheres to the release stack via the adhesion layer, occurs via a process of de-wetting. The surface energy of the absorption layer is higher than the surface tension of the molten melting layer. At the same time, the surface tension of the molten melting layer is higher than the surface energy of the adhesion layer. Therefore, when the melting layer is molten, adhesion between the absorption layer and melting layer will be maintained, but adhesion between the melting layer and the adhesion layer will be lost, resulting in the release of the component. To this end, the absorption layer and the melting layer are typically provided as metallic layers, while the adhesion layer is typically provided as a polymeric layer. The components are typically also of polymeric materials. By providing the melting layer with a thickness, such as to obtain a release period that is shorter than the scan period, it is enabled to scan the full surface of components for controlled release thereof. The donor substrate according to the second aspect of the invention thereby advantageously makes the method according to the first aspect of the invention suitable for larger components.

In accordance with some embodiments of the invention, the melting layer has a thickness between 50 nm and 1 µm, preferably between 100 nm and 750 nm, more preferably between 250 nm and 500 nm. Advantageously, by providing the melting layer with a thickness as mentioned above, the release period is ensured to be sufficiently long to enable components to be released by means of scanning the full surface thereof with the light beam, rather than illuminating the full surface at once. In alternative embodiments, other parameters, such as the thickness of the absorption layer, or the melting temperatures of the absorption layer or the melting layer, of the release stack may be altered, such as to provide a release period sufficiently long for enabling a full surface of a component to be scanned.

In accordance with some embodiments of the invention, the melting layer has a melting temperature between the melting layer has a melting temperature between 100 °C and 1000 °C, preferably between 100 °C and 750 °C, more preferably between 150 °C and 250 °C. Preferably, the melting layer is provided having a lower melting temperature, in order to optimize the energy efficiency of the method, as lower melting points reduce the required laser fluence.

In accordance with a third aspect of the invention, there is provided herewith a system
for use in a method of light-induced controlled release of one or more components according to any of the claims 1-8, wherein the system comprises:
   - the donor substrate according to any of the claims 9-11;
   - an acceptor substrate;
   - a controller; and
   - a light source for emitting a light beam,
wherein the donor substrate comprises a transparent carrier for being illuminated with the light beam, the light beam having an optical power and the light beam having a beam diameter defining a cross-section of the light beam,
   wherein the donor substrate comprises a stack of layers forming a release stack on the transparent carrier for receiving optical energy from the light beam for releasing of at least one of the one or more components to the acceptor substrate after a release period, wherein the release period is determined by an amount of received optical energy necessary for releasing the at least one component, wherein the release stack comprises:
      - an absorption layer for absorbing the optical energy, the absorption layer having a first melting temperature;
      - a melting layer for being melted by heat from the absorption layer, the melting layer having a second melting temperature below the first melting temperature; and
      - an adhesive layer for adhering the components to the melting layer, and for releasing the at least one component to the acceptor substrate when the melting layer is in a molten state; wherein the melting layer has a predefined thickness for predefining the amount of optical energy to be received for releasing the at least one component, such as to establish a predefined release period determined by the optical power of the light beam; and
   wherein the light source is configured for scanning, during a scan period shorter than the predefined release period, a full surface of the at least one component with the light beam along a scanning path, for providing the optical energy to the absorption layer, for releasing the at least one component.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figures 1A and 1B schematically illustrate a side view of a system in accordance with an embodiment of the third aspect of the invention in use.
Figure 2 schematically illustrates a bottom view of three closely spaced, high aspect ratio components carried by a donor substrate in accordance with an embodiment of the second aspect of the invention in use.
Figure 3 schematically illustrates a bottom view of a plurality of components carried by a donor substrate in accordance with an embodiment of the second aspect of the invention in use, wherein the scanning path is a spiraling path.
Figure 4A schematically illustrates a close-up side view of a component attached to a donor substrate in accordance with an embodiment of the second aspect of the invention in use.
Figure 4B schematically illustrates a timeline of the light-induced release of a component in accordance with an embodiment of the first aspect of the invention.

### Detailed description

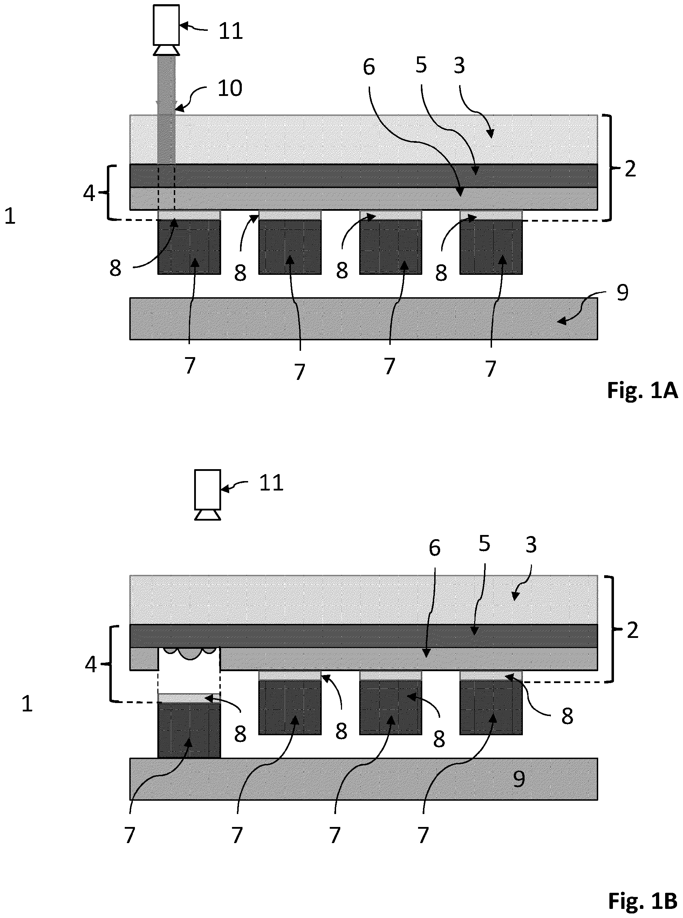

Figures 1A and 1B schematically illustrate a side view of a system according to the third aspect of the invention in use. The system 1 comprises a donor substrate 2, which comprises a transparent carrier 3 and a release stack 4. The release stack 4 comprises an absorption layer 5 and a melting layer 6. Figures 1A and 1B further show four components 7 carried by the donor substrate, each of which is attached thereto via an adhesive layer 8 of the release stack 4. Figures 1A and 1B further show an acceptor substrate 9 of the system 1 for receiving the components 7. Figure 1A shows the donor substrate 2 before a component 7 is released to the acceptor substrate 9, while figure 1B shows the system 1 after the component 7 has been released. When executing a method according to the first aspect of the invention, the transparent carrier 3 of the donor substrate 2 is illuminated with a light beam 10 from a light source 11. The light source 11 is shown in the figure directly illuminating the donor substrate 2. However, in alternative embodiments, the light beam 10 may be led through beam shaping optics (not shown) for forming the light beam 10 into a desired shape, such as having a desired width. The light beam 10, incident on the transparent carrier 3 is refracted through the transparent carrier 3 and reaches the absorption layer 5. Upon receiving the optical energy of the light beam 10, the absorption layer 5 absorbs it and consequently generates heat. The heat is then conducted to the melting layer 6, which is in direct thermal contact with the absorption layer 5. The absorption layer 5 has a first melting temperature and the melting layer 6 has a second melting temperature, which is lower than the first melting temperature. Furthermore, the light beam 10 is provided to the donor substrate 2 with sufficiently high optical energy, such that the melting layer 6 is melted by the heat generated in the absorption layer 5. However, the first melting layer is higher than the second to such an extent, that the absorption layer 5 remains solid. Furthermore, the light beam 10 is provided with a width that covers only a portion of the full surface of the component 7. The melting layer 6 will only be caused to melt within the corresponding portion of the melting layer. The full surface of the component 7 is therefore scanned with the light beam 10 within a scan period. When the melting layer 6, which is typically provided as a metallic layer, is in a molten state, the surface tension of the melting layer 6 will be below the surface energy of the absorption layer 5, which is typically also provided as a metallic layer, but it will be higher than the surface energy of the typically polymeric adhesive layer 8. As a consequence, de-wetting will occur, wherein adhesion between the absorption layer 5 and the melting layer 6 will be preserved, but adhesion between the melting layer 6 and the adhesion layer 8 will be lost. When this is the case across the full surface of the component 7, as shown in figure 1B, it will result in the release of the component 7 to the acceptor substrate 9.

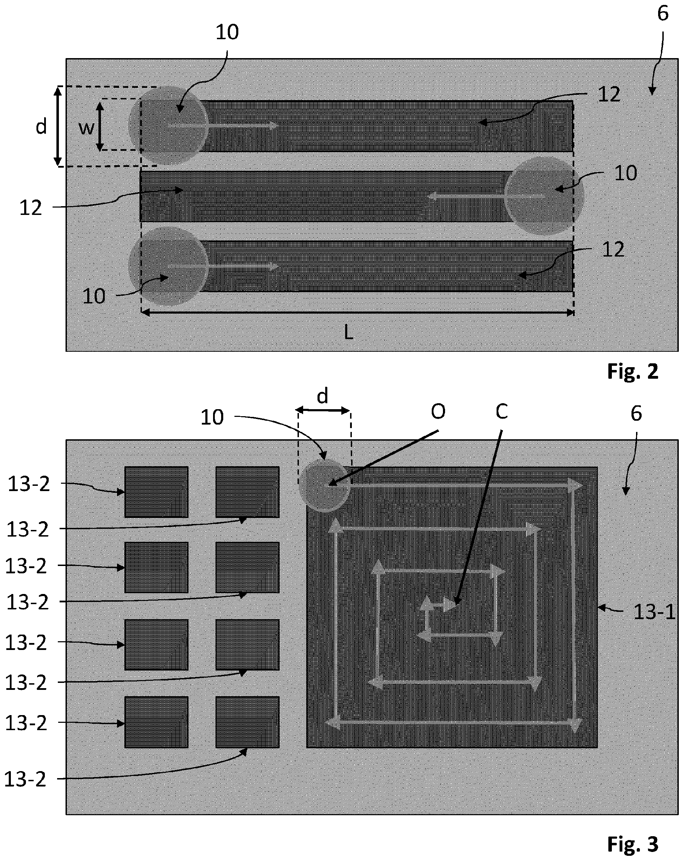

Figure 2 schematically illustrates a bottom view of three closely spaced, high aspect ratio components 12 carried by a donor substrate 2 according to the second aspect of the invention in use. For illustrative purposes, light beams 10 that may be used for release of these components are made visible in front of the components 12. When carrying out the method according to the first aspect of the invention however, the light beam 10 is introduced from the opposite direction. The high aspect ratio components 12 would ordinarily have to be illuminated with a light beam 10 sufficiently wide to cover the length L of the components. Furthermore, ordinarily a mask would need to be employed for enabling the selective release of specific components. However, in the present invention, the melting layer 6 of the donor substrate 2 is provided with a thickness that provides the substrate with a release period that is longer than the scan period. This enables to use a light beam 10 having a beam diameter d that for example - as shown in the figure - is only sufficiently wide to cover the width w of the component 12. The component 12 can then be scanned in a scanning path that is a straight line covering the length L of the component. In alternative embodiments, the width d of the light beam can of course be chosen even smaller, but an alternative scanning path would then also need to be defined. The width d of the beam may also be chosen larger, which would have the consequence that the scanning path becomes shorter. The closely spaced components 12 depicted in the figure can each be selectively released to the acceptor substrate 9 consecutively. For example, the top-most component 12 can be released first by scanning from left to right, followed by the middle component 12 by scanning from right to left, followed by the bottom-most component 12 by scanning from left to right again. Furthermore, since the light beam 10 is typically a pulsed laser light beam having a predetermined laser period, the scanning may be performed in one of two ways. For example, the scan period may be shorter than the laser period, such that the full surface of a component is scanned within a single laser period. In that case, the light beam 10 moves across the full surface of the component within the duration of a single pulse. Alternatively however, the scan period may be longer than the laser period, such that the full surface of the component is scanned within a plurality of laser periods. The scanning path may then be viewed as a series of adjacent portions of the full surface, wherein each portion is illuminated consecutively.

Figure 3 schematically illustrates a bottom view of a plurality of components 13 carried by a donor substrate 2 according to the second aspect of the invention in use, wherein the scanning path is a spiraling path. For illustrative purposes, a light beam 10 that may be used for release of these components 13 is made visible in front of the components 13. When carrying out the method according to the first aspect of the invention however, the light beam 10 is introduced from the opposite direction. Figure 3 shows a large component 13-1 and multiple smaller components 13-2 attached to the donor substrate 2. Ordinarily, any component 13 would be illuminated fully with a light beam 10 sufficiently wide for that component 13 for the release thereof to an acceptor substrate 9. The laser power required for releasing the components 13 to an acceptor substrate 9 would then scale with the dimensions of the component 13 to be transferred. However, in the present invention, the melting layer 6 of the donor substrate 2 is provided with a thickness that provides the substrate 2 with a release period that is longer than the scan period. This enables to use a light beam 10 having a beam diameter d that is only sufficiently wide to cover a small portion of the width w of the component 13-1, and to scan the full surface of the component 13-1 with such a narrow light beam 10 along a spiraling scanning path. The spiraling scanning path runs between a center point C near the center of the component 13-1 and an outer point O near an outer edge of the component 13-1. The scanning path may then be followed from the center point C outwards, towards the outer point O, as shown in the figure. Alternatively, the path may be followed in the opposite direction. Both directions are suitable for achieving a controlled release of the component 13-1 to the acceptor substrate 9, wherein the component 13-1 is released from the donor substrate 2 evenly across the full surface of the component 13-1. In alternative embodiments, the scanning path may not be a spiraling path, but may for example be a meandering path, which runs across a set of adjacent linear subpaths. Alternatively the scanning path may be an iterative path running across a same set of linear subpaths.

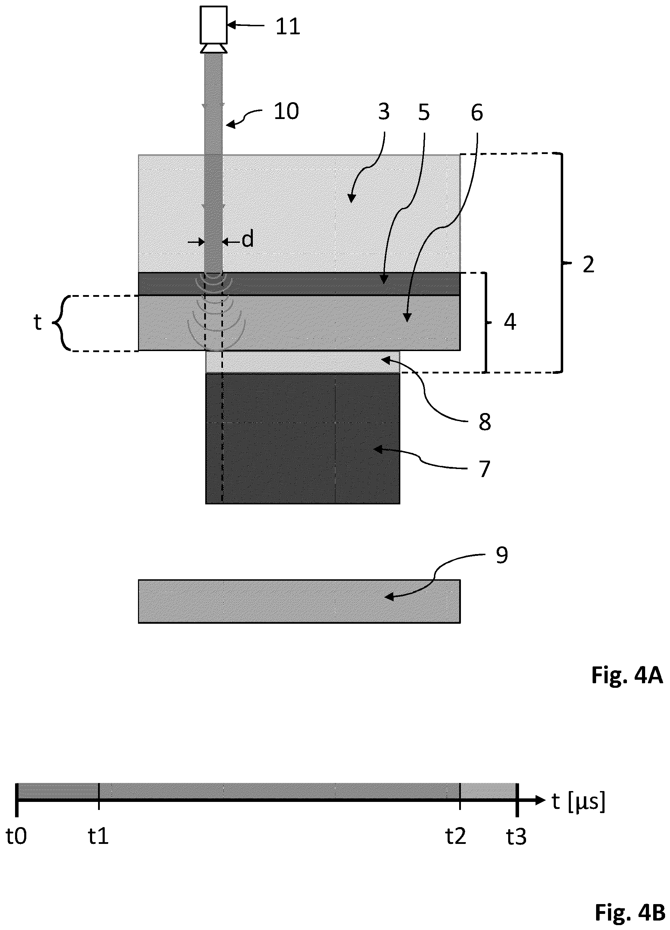

Figure 4A schematically illustrates a close-up side view of a component 7 carried by a donor substrate 2. When executing a method in accordance with an embodiment of the first aspect of the invention, the transparent carrier 3 is illuminated with a light beam 10 from a light source 11. The light beam 10 has a light beam diameter d, which covers only a fraction of the width w of the component 7. Furthermore, the melting layer 6 of the donor substrate 2 is provided with a thickness t. The thickness t, the optical power of the light beam 10 and the beam diameter d in combination predefine a release period. The thicker the melting layer 6, the longer the release period. The higher the optical power of the beam 10, the shorter the release period. The wider the beam diameter d, the longer the release period. Any of these parameters may be varied to provide a release period that is suitably long for enabling scanning of the component 7 with the beam 10.

Figure 4B schematically illustrates a timeline of the light-induced release of a component from a donor substrate 2 to an acceptor substrate 9 through a method in accordance with an embodiment of the first aspect of the invention. At t0, a light beam 10 from a light source 11 is incident on the transparent carrier 3. The light then passes through the carrier and reaches the absorption layer 5. The absorption layer 5 consequently locally generates heat therein. Meanwhile, the light beam 10 is scanning the full surface of the component 7 and is finished at t1. In other words, the scan period is between t0 and t1. The heat generated locally at each illuminated point of the absorption layer 5 reaches the melting layer 6, is conducted from the top of the layer to the bottom, and causes the melting layer to melt. At t2 the melting layer 6 enters a molten state at the bottom of the layer across the full surface of the component 7. At this time, de-wetting starts to occur. Because the surface energy of the absorption layer 5 is higher than the surface tension of the molten melting layer 6 and the surface tension of the molten melting layer 6 is higher than the surface energy of the adhesion layer 8, when the melting layer 6 is molten, adhesion between the absorption layer 5 and melting layer 6 will be maintained, but adhesion between the melting layer 6 and the adhesion layer 8 will be lost, resulting in the release of the component 7 to the acceptor substrate 9 at t3.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Method of light-induced release of one or more components from a donor substrate to an acceptor substrate, wherein the method comprises:
providing the donor substrate, the donor substrate comprising a transparent carrier for being illuminated with a light beam from a light source, the light beam having an optical power and the light beam having a beam diameter defining a cross-section of the light beam, the donor substrate further comprising a stack of layers forming a release stack on the transparent carrier for receiving optical energy from the light beam for releasing of at least one of the one or more components to the acceptor substrate after a release period, wherein the release period is determined by an amount of received optical energy necessary for releasing the at least one component, wherein the release stack comprises:
- an absorption layer for absorbing the optical energy, the absorption layer having a first melting temperature;
- a melting layer for being melted by heat from the absorption layer, the melting layer having a second melting temperature below the first melting temperature; and
- an adhesive layer for adhering the components to the melting layer, and for releasing the at least one component to the acceptor substrate when the melting layer is in a molten state; wherein the method further comprises:
providing the melting layer having a predefined thickness for predefining the amount of optical energy to be received for releasing the at least one component, such as to establish a predefined release period determined by the optical power of the light beam; and
scanning, during a scan period shorter than the predefined release period, a full surface of the at least one component with the light beam along a scanning path, for providing the optical energy to the absorption layer, for releasing the at least one component.

2. Method according to claim 1, wherein the melting layer of the donor substrate is provided having a thickness such that the release period is substantially longer than the scan period.

3. Method according to claim 1 or 2, wherein the beam diameter of the light beam is controllable, and wherein the method comprises a step of determining the beam diameter such as to provide the beam having a predefined light beam fluence.

4. Method according to any one or more of the preceding claims, wherein based on the beam diameter, the method further comprises, prior to scanning the full surface of the at least one component, determining the scanning path of the light beam such that the scanning path completely covers said full surface during said scanning.

5. Method according to any of the preceding claims, the method further comprising, prior to scanning the full surface of the at least one component, controlling the optical power of the light beam for illuminating the carrier.

6. Method according to any of the claims 3-5, the method further comprising, prior to scanning the full surface of the at least one component, determining a scan velocity of the light beam dependent on at least one of: the beam diameter, the scanning path or the optical power, for predetermining the scan period for scanning the full surface.

7. Method according to any of the preceding claims, wherein the release period is at least twice as long as the scan period, preferably at least five times as long as the scan period, more preferably at least ten times as long as the scan period.

8. Method according to any of the preceding claims, wherein one of:
- the scanning path is a straight linear path;
- the scanning path is a set of adjacent linear subpaths, wherein, starting from a first subpath arranged along an outer edge of the full surface of the at least one component, the full surface is scanned by consecutively scanning an adjacent subpath; or
- the scanning path is a spiraling path between a center point near a center of the target surface portion and an outer point near an outer edge of the target surface portion.

9. Method according to any of the preceding claims, wherein the light beam is a pulsed light beam having a predetermined laser period, wherein one of:
- the scan period is shorter than the laser period, such that the full surface of the at least one component is scanned within a single laser period; or
- the scan period is longer than the laser period, such that the full surface of the at least one component is scanned within a plurality of laser periods.

10. Donor substrate for use in a method according to any one or more of the preceding claims, for a light-induced release of one or more components to an acceptor substrate, the donor substrate comprising a transparent carrier for being illuminated with a light beam from a light source, the light beam having an optical power and the light beam having a beam diameter defining a cross-section of the light beam, the donor substrate further comprising a stack of layers forming a release stack on the transparent carrier for receiving optical energy from the light beam for releasing of at least one of the one or more components to the acceptor substrate after a release period, wherein the release period is determined by an amount of received optical energy necessary for releasing the at least one component, wherein the release stack comprises:
- an absorption layer for absorbing the optical energy, the absorption layer having a first melting temperature;
- a melting layer for being melted by heat from the absorption layer, the melting layer having a second melting temperature below the first melting temperature; and
- an adhesive layer for adhering the components to the melting layer, and for releasing the at least one component to the acceptor substrate when the melting layer is in a molten state,
wherein the melting layer has a thickness such as to predetermine the amount of optical energy to be received for releasing the at least one component, such as to establish a predefined release period determined by the optical power of the light beam in use, such as to enable the release period to include a scan period shorter than the predefined release period, for enabling scanning of a full surface of the at least one component with the light beam along a scanning path, for providing the optical energy to the absorption layer, for releasing the at least one component.

11. Donor substrate according to claim 10, wherein the melting layer has a thickness between 50 nm and 1 µm, preferably between 100 nm and 750 nm, more preferably between 250 nm and 500 nm.

12. Donor substrate according to claim 10 or 11, wherein the melting layer has a melting temperature between 100 °C and 1000 °C, preferably between 100 °C and 750 °C, more preferably between 150 °C and 250 °C.

13. System for use in a method of light-induced controlled release of one or more components according to any of the claims 1-9, wherein the system comprises:
- the donor substrate according to any of the claims 10-12;
- an acceptor substrate;
- a controller; and
- a light source for emitting a light beam,
wherein the donor substrate comprises a transparent carrier for being illuminated with the light beam, the light beam having an optical power and the light beam having a beam diameter defining a cross-section of the light beam,
wherein the donor substrate comprises a stack of layers forming a release stack on the transparent carrier for receiving optical energy from the light beam for releasing of at least one of the one or more components to the acceptor substrate after a release period, wherein the release period is determined by an amount of received optical energy necessary for releasing the at least one component, wherein the release stack comprises:
- an absorption layer for absorbing the optical energy, the absorption layer having a first melting temperature;
- a melting layer for being melted by heat from the absorption layer, the melting layer having a second melting temperature below the first melting temperature; and
- an adhesive layer for adhering the components to the melting layer, and for releasing the at least one component to the acceptor substrate when the melting layer is in a molten state; wherein the melting layer has a predefined thickness for predefining the amount of optical energy to be received for releasing the at least one component, such as to establish a predefined release period determined by the optical power of the light beam; and
wherein the light source is configured for scanning, during a scan period shorter than the predefined release period, a full surface of the at least one component with the light beam along a scanning path, for providing the optical energy to the absorption layer, for releasing the at least one component.
